# EUROPÄISCHE PATENTSCHRIFT

(11) **EP 1 113 980 B1**
(45) Veröffentlichungstag und Bekanntmachung des Hinweises auf die Patenterteilung: **07.11.2018**
(21) Anmeldenummer: 99950524.1
(22) Anmeldetag: 10.09.1999
(51) Int. Cl.: B81C 1/00, G01Q 60/06, G01Q 60/22, G01Q 60/38

(54) **APERTUR IN EINEM HALBLEITERMATERIAL SOWIE HERSTELLUNG DER APERTUR UND VERWENDUNG**
APERTURE IN A SEMICONDUCTOR MATERIAL, AND THE PRODUCTION AND USE THEREOF
OUVERTURE PRATIQUEE DANS UN MATERIAU SEMI-CONDUCTEUR ET REALISATION DE CETTE OUVERTURE ET SON UTILISATION

(30) Priorität: 12.09.1998 DE 19841909; 11.06.1999 DE 19926601
(43) Veröffentlichungstag der Anmeldung: 11.07.2001
(73) Patentinhaber: WITec Wissenschaftliche Instrumente und Technologie GmbH, 89081 Ulm (DE)
(72) Erfinder: KASSING, Rainer, D-34128 Kassel (DE); MIHALCEA, Christophe, D-34119 Kassel (DE); OESTERSCHULZE, Egbert, D-34134 Kassel (DE)
(74) Vertreter: Sawodny, Michael-Wolfgang
(86) Internationale Anmeldenummer: PCT/EP1999/006685
(87) Internationale Veröffentlichungsnummer: WO 2000/015544

(56) Entgegenhaltungen:
- EP-A- 0 786 642
- DE-A1- 4 310 604
- US-A- 5 272 913
- MIHALCEA C ET AL: "MULTIPURPOSE SENSOR TIPS FOR SCANNING NEAR-FIELD MICROSCOPY" APPLIED PHYSICS LETTERS,US,AMERICAN INSTITUTE OF PHYSICS. NEW YORK, Bd. 68, Nr. 25, Seite 3531-3533 XP000599562 ISSN: 0003-6951

## Beschreibung

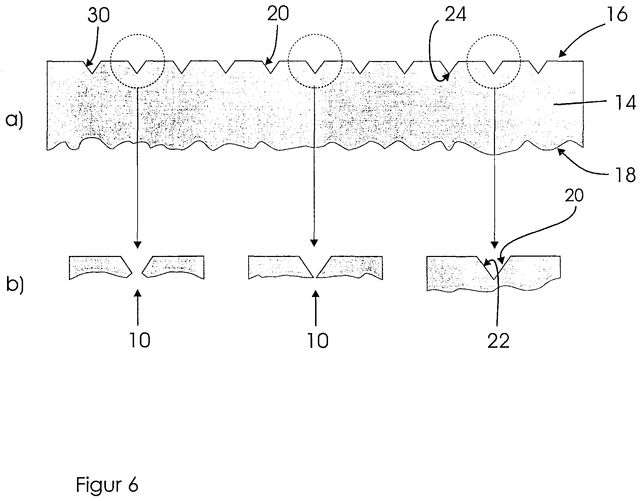

Die Erfindung betrifft ein Verfahren zur Herstellung einer Apertur in einem Halbleitermaterial, wie zum Beispiel (100)-orientiertes oder polykristallines Silizium. Derartige Aperturen, deren Größe im Mikrometerbereich oder darunter liegen, werden beispielsweise als Bestandteil von Sonden der optischen Raster-Nahfeld-Mikroskope (SNOM) eingesetzt. Mit dieser Technik können optische Oberflächeneigenschaften mit Subwellenlängen-Auflösung untersucht werden. Wie bei allen Raster-Sonnen-Mikroskopen wird die erzielbare Auflösung auch beim optischen Raster-Nahfeld-Mikroskop durch die Geometrie und Abmessung der Sonde, das heißt insbesondere der Apertur, sowie deren Abstand zur Probenoberfläche limitiert. Um Subwellenlängen-Auflösung zu erreichen, ist es erforderlich, daß der lichtemittierende oder detektierende Bereich der Sonde laterale Abmessungen unter 100 nm aufweisen. Im Stand der Technik hat es nicht an Versuchen gefehlt, derartig kleindimensionierte Aperturen im 100 nm-Bereich beziehungsweise darunter reproduzierbar herzustellen. Ein aus dem Stand der Technik bekanntes Verfahren ist in Figur 6 schematisch dargestellt. In Figur 6a ist der Querschnitt durch einen Halbleiterwafer 14 wiedergegeben, der eine Oberfläche 16 und eine Unterfläche 18 aufweist. In der Oberfläche 16 sind eine Mehrzahl von Vertiefungen 20, beispielsweise in Form einer inversen Pyramide 30, durch bevorzugt anisotropes Ätzen eingebracht. Anschließend wird die Unterfläche 18 des Halbleiterwafers 14, der beispielsweise aus (100)-orientiertem Silizium besteht, durch insbesondere anisotropes Ätzen rückgeätzt, bis die Spitzen der inversen Pyramiden freigelegt sind und somit eine Apertur 10 entsteht, wie dies in Figur 6b, erste und zweite Darstellung, schematisch dargestellt ist. Die erste Apertur weist eine zu große Öffnungsweite auf, die zweite Apertur besitzt eine ideale Öffnungsweite, während für das dritte Beispiel die Spitze der inversen Pyramide überhaupt noch nicht geöffnet ist. Dies ist darauf zurückzuführen, daß die Dicke des Halbleiterwafers stark variiert. Bereits Dickenschwankungen von einigen 10 nm können zu den in Figur 6 dargestellten Schwankungen des Durchmessers beziehungsweise Querschnitts der Apertur führen. Dieses Beispiel nach dem Stand der Technik verdeutlicht, daß aufgrund der Schwankungen der Dicke des Halbleiterwafers 14 nur sehr wenige Spitzen der inversen Pyramiden geeignete Aperturgrößen besitzen. Außerdem streuen die Abmessungen dieser Apertur äußerst stark.

Weiterhin haben aus dem Stand der Technik bekannte Untersuchungen zum Oxidationsverhalten von Silizium (Markus et al., Journal of the Electrochemical Society, Solid State Science and Technology, pp 1278-1282, 1982 beziehungsweise Kao et al., IEE Transactions on Electronic Devices, Volume 34, No. 5, pp 1008, 1987 sowie Volume 35, No. 1, pp 25, 1988) eine starke Abhängigkeit von der Orientierung in der Ebene des Halbleiterwafers von der Temperatur und der Struktur der Oberfläche ergeben. Es konnte nachgewiesen werden, daß bei niedrigen Oxidationstemperaturen von etwa 800° C bis 900° C die Oxidschichtdicke an konvexen und konkaven Kanten der strukturierten Oberfläche, zum Beispiel bei Trenchzellen, gegenüber der Oxidschichtdicke auf der Oberfläche reduziert ist. Diese Erkenntnisse wurden bereits dazu benutzt, sehr scharfe Siliziumspitzen herzustellen (Marcus et al, Applied Physics letters, 54 (3), pp 236-238, 1990). Dabei konnten Krümmungsradien im Bereich von etwa 1 nm erreicht werden. Ein ähnliches Verfahren zur Herstellung von sehr scharfen Siliziumspitzen für in der Rastersondenmikroskopie verwendete sogenannte Cantileversonden ist in der EP-A-0468071 beschrieben.

Zum Stand der Technik zählt auch die US-B 5,272,913. Die US-B-5,272,913 zeigt einen Cantilever für ein scanning probe Mikroskop, wobei zur Herstellung des Cantilevers ein Halbleiterverfahren eingesetzt wird.

Aus der EP-A-0 786 642 ist ein Verfahren zur Herstellung einer Spitze zur Detektion eines Tunnelstromes oder von Mikrokräften oder Magnetkräften bekannt geworden.

Die DE-A-43 10 604 zeigt einen Feldemissionskathodenaufbau, bei dem ein Loch mit spitz zulaufendem Boden in einem ersten Substrat ausgebildet wird. Als Verfahren zur Herstellung eines derartigen Loches wird das anisotrope Ätzen eines Si-Einkristall-Substrates beschrieben.

Ausgehend von einem Verfahren zur Herstellung einer Apertur in einem Halbleitermaterial mit den Schritten Bereitstellen eines Halbleiterwafers, beispielsweise eines (100)-orientierten Siliziumwafers mit einer Oberfläche und einer Unterfläche und Erzeugen einer Vertiefung mit einer Seitenwand in der Oberfläche des Halbleiterwafers durch partielles Anätzen der Oberfläche, liegt der vorliegenden Erfindung die Aufgabe zugrunde, ein Verfahren zur Herstellung einer Apertur zu schaffen, deren Größe unterhalb von ca. 1 Mikrometer, insbesondere bei ca. 100 nm liegt, wobei die Größe der Apertur reproduzierbar einstellbar ist.

Diese Aufgabe wird mit einem Verfahren gemäß Anspruch 1 gelöst. Bei dem erfindungsgemäßen Verfahren ist vorgesehen, dass die
Vertiefung einen der Unterfläche zugewandten, geschlossenen Bodenbereich bevorzugt mit insbesondere einer konvexen oder insbesondere einer konkaven Ecke oder Kante oder dergleichen Krümmung aufweist, eine Oxidschicht auf das Halbleitermaterial wenigstens im Bereich der Vertiefung durch Oxidation des Halbleitermaterials aufgebracht wird, wobei die Oxidschicht wenigstens im Bodenbereich eine Inhomogenität aufweist, das Halbleitermaterial an der Unterfläche des Halbleiterwafers bis zum Freilegen wenigstens der im Bodenbereich befindlichen Oxidschicht selektiv rückgeätzt wird und die freigelegte Oxidschicht bis wenigstens zu deren Durchtrennung angeätzt wird.

Das Verfahren weist den besonderen Vorteil auf, daß die Messung der Größe der Apertur unabhängig von Schichtdickenvariationen des Halbleiterwafers ist. Dies hat zur Folge, daß die herzustellenden Aperturen äußerst reproduzierbar zu fertigen sind und demzufolge beispielsweise beim Einsatz bei Sonden in der optischen Rasternahfeldmikroskopie neue Anwendungsgebiete und Auflösungen erschließen können.

Zur Herstellung von Aperturen in halbleitenden Materialien, zum Beispiel in (100)-orientiertem einkristallinem Silizium oder polykristallinem Silizium, werden eine Reihe von Verfahrensschritten angewandt. Zunächst werden insbesondere pyramidale oder sonstige Vertiefungen geformt, die in der Tiefe spitz zulaufen und in das Halbleitermaterial eingeätzt werden. Dazu sind Maskierungsschichten auf der Oberfläche des-Halbleiterwafers aufgebracht. Durch optische oder Elektronenstrahl-Lithographie und anschließende, chemische, elektrochemische oder Plasmaätzverfahren werden die erforderlichen Strukturen in die Maskierungsschicht übertragen. Die Ätzung der Vertiefungen erfolgt durch naßchemische oder Plasmaätzverfahren. Alternativ können die Vertiefungen auch durch einen fokussierten Ionenstrahl erzeugt werden. In einem weiteren Schritt wird das Halbleitermaterial oxidiert, wobei die entstehende Oxidschichtdicke variiert in Abhängigkeit von der Kristallorientierung, der Oxidationstemperatur und der Krümmung der jeweiligen, lokalen Struktur der Oberfläche des Halbleiterwafers. Bei Wahl geeigneter Oxidationstemperaturen weist die Oxidschicht an den Stellen größter Krümmung aufgrund von Streßeffekten eine erhöhte Ätzrate auf, das heißt, daß die Oxidschicht beispielsweise für den Fall einer spitz zulaufenden Vertiefung im Spitzenbereich eine oder mehrere bezüglich der Ätzprozesse "Schwachstellen" aufweist. In einem weiteren Schritt wird die gegebenenfalls während des oxidationsprozesses auf der Unterfläche des Halbleiterwafers entstandene Oxidschicht mit bekannten Techniken entfernt. Anschließend wird durch naßchemisches Ätzen oder Plasmaätzen das Halbleitermaterial an der Unterfläche zurückgeätzt, bis schließlich die Spitze der in der Vertiefung befindlichen Oxidschicht freigelegt ist. Wichtig ist, daß hierbei eine selektive Ätzmethode angewendet wird, um auch eine Ätzung der Oxidschicht völlig oder jedenfalls weitestgehend zu vermeiden. Das Rückätzen des Halbleitermaterials wird solange durchgeführt, bis die eine oder sämtliche Oxidschichten beispielsweise eines Arrays von Vertiefungen freigelegt sind. Dabei kann es aufgrund von Dickeschwankungen des Halbleiterwafers durchaus vorkommen, daß die ggf. mehreren Spitzen der Oxidschicht mehr oder minder weit aus der Unterfläche des Halbleiterwafers herausragen. Dies ist jedoch insoweit unproblematisch für die Bemessung der Größe der Apertur, als die mehr oder minder weit herausragenden Spitzen der Oxidschicht jedenfalls in Bezug aufdie Dicke und Form der Oxidschicht untereinander im wesentlichen die gleiche Form aufweisen und insbesondere im Bereich der Spitze jeweils ein oder mehrere Schwachstellen besitzen. Anschließend wird die Oxidschicht mit einer gegenüber dem Material der Oxidschicht selektiven Ätze abgedünnt, bis an den "Schwachstellen" der Oxidschicht die Oxidschicht durchbrochen wird und die gewünschten Aperturen in den Oxidstümpfen entstehen. Sofern keine größeren Aperturen erwünscht sind, wird der Ätzprozeß anschließend abgebrochen.

Durch dieses Verfahren werden somit miniaturisierte Aperturen wohldefinierter Größe auf dem ganzen Halbleiterwafer erzeugt. Wird der Ätzprozeß jedoch weiter fortgesetzt, wird auch der Stumpf der Oxidschicht weiter geätzt, so daß man Aperturen mit über die Dauer des Ätzvorganges einstellbarer Größe erhält.

Des weiteren besteht auch die Möglichkeit, die erzeugten Vertiefungen im Bodenbereich mit einer Schneide beziehungsweise einem Plateau zu versehen, so daß durch den beschriebenen Prozeß auch zwei beziehungsweise vier Öffnungen pro Vertiefung in der Oxidschicht im Bereich deren Spitze erzeugt werden können.

Der Reproduzierbarkeit des Verfahrens liegt die Erkenntnis zugrunde, die speziellen Oxidationseigenschaften beispielsweise von (100)-orientierten Siliziumwafern für die Herstellung von reproduzierbaren Aperturen gleicher Größe über die ganze Substratoberfläche trotz schwankender Substratdicke auszunutzen. Dazu wird das die Vertiefung tragende Substrat bei etwa 800° C bis 900° C oxidiert, so daß es zur Ausbildung einer Oxidschichtdicke mit inhomogener Ätzrate und auch Schichtdicke kommt. Das Oxid ist an den Stellen größter Krümmung am dünnsten, das heißt, daß die verdünnten Oxidschichtabschnitte im Bereich der Spitze der Vertiefungen angeordnet sind. Die Oxidschichten in den mehreren Vertiefungen werden durch selektives Rückätzen des Halbleitermaterials an der Unterfläche des Halbleiterwafers freigelegt, wobei die Oxidschicht durch diesen Verfahrensschritt nicht oder nur geringfügig angegriffen wird. In dieser Phase des Herstellungsverfahrens weisen alle durch die Oxidschicht abgeformten Vertiefungen exakt die gleiche Oxidschichtstruktur auf. Insbesondere ist die Oxidschichtstruktur unabhängig von Dickenvariationen des Halbleitermaterials. Alle im wesentlichen identischen, freigelegten Spitzen der Oxidschicht können in einem anschließenden Schritt mit einer selektiven Ätze abgedünnt beziehungsweise abgetragen werden, bis die Oxidschicht aller Spitzen jeweils an der gleichen Stelle, nämlich der Schwachstelle der Oxidschicht, durchbrochen wird und die Spitze der Oxidschicht abfällt. Hierdurch werden in sämtlichen Oxidstümpfen Aperturen mit praktisch gleicher Größe über die ganz Oberfläche des Halbleiterwafers erhalten.

Nach einer vorteilhaften Ausgestaltung der Erfindung weisen die Vertiefungen die Form einer inversen Pyramide oder eines V-förmigen Grabens oder eines inversen Pyramidenstumpfes oder eine Plateauform auf.

Insbesondere sind die Vertiefungen in einer Vielzahl, zum Beispiel in Form eines Arrays, auf der Oberfläche des Halbleiterwafers angeordnet.

Von besonderem Vorteil weist die Oxidschicht im Bodenbereich als Inhomogenität eine oder mehrere Schwachstellen beziehungsweise Verjüngungen auf.

Von Vorteil wird die Oberfläche der Oxidschicht nach dem Durchtrennen einem Metallisierungsprozeß, insbesondere mit Aluminium, unterworfen. Hierdurch besteht die Möglichkeit, die in der Oxidschicht bereits vorhandene Apertur gezielt zu verkleinern. Eine Metallisierung sorgt auch für eine Verbesserung der optischen Eigenschaften eines mit einer solchen Apertur ausgestatteten Sensors.

Der Durchmesser der Apertur liegt von Vorteil in der Größenordnung von ca. 100 nm oder weniger.

Die Vertiefungen werden nach einer anderen vorteilhaften Ausgestaltung des Verfahrens bevorzugt durch anisotropes Ätzen erzeugt.

Die Oxidschicht wird durch Erhitzen des Halbleiterwafers auf ca. 900° C, insbesondere in feuchter Atmosphäre und bevorzugt für ca. 2 Stunden erzeugt.

Das selektive Rückätzen des Halbleitermaterials erfolgt isotrop oder anisotrop zum Beispiel mittels einer KOH-Lösung, insbesondere ca. 40 Gew. %, bei bevorzugt ca. 60° C.

Das selektive Rückätzen des Halbleitermaterials erfolgt bevorzugt solange, bis die Oxidschichten bevorzugt im wesentlichen aller oder wenigstens einer Mehrzahl der Vertiefungen des Halbleiterwafers freigelegt sind.

Das Anätzen der freigelegten Oxidschicht wird bevorzugt mit Ammoniumfluoridpuffer, insbesondere 1 Puffer:16 Wasser, durchgeführt.

Die Größe der Apertur wird im wesentlichen durch die Dauer das Anätzens der Oxidschicht nach deren Durchtrennung hin zu größeren Werten variiert.

Nach einer anderen vorteilhaften Ausgestaltung sind die Vertiefungen schneidenförmig beziehungsweise plateauförmig zulaufend ausgebildet, wobei je Vertiefung zwei beziehungsweise vier Aperturen hergestellt werden.

Die Erfindung betrifft auch eine Apertur in einem Halbleitermaterial, insbesondere hergestellte nach einem der Verfahrensansprüche, wobei die Apertur durch eine auf einer Innenwandung einer Durchbrechung im Halbleitermaterial befindlichen Oxidschicht gebildet ist.

Nach einer Ausgestaltung der Erfindung ist auf die Oxidschicht eine Halbleiterschicht und/oder eine organische Materialschicht und/oder eine Metallschicht, insbesondere eine Aluminiumschicht, aufgebracht.

Dabei hat es sich als vorteilhaft erwiesen, daß die Oxidschicht aus einem Oxid des Halbleitermaterials gebildet ist.

Die Erfindung betrifft auch eine Verwendung einer Apertur, die dadurch gekennzeichnet ist, daß das Halbleitermaterial mit der Apertur insbesondere in dem vorderen Bereich eines einseitig eingespannten Biegebalkens, insbesondere eines sogenannten Cantilevers, integriert sind.

Dabei besteht eine vorteilhafte Ausgestaltung der Verwendung darin, daß der Biegebalken einzeln oder eine Mehrzahl von Biegebalken in einer Matrixanordnung als Sensorelement eingesetzt sind.

Nach einer anderen vorteilhaften Ausgestaltung werden der oder die Biegebalken als Sensorelemente in der Rastersondenmikroskopie eingesetzt.

Dabei hat es sich als vorteilhaft erwiesen, daß durch Deposition einer dünnen, optisch wenig transparenten Schicht der oder die Biegebalken für die simultane Rasterkraftmikroskopie (AFM, SFM) oder die optische Rasternahfeldmikroskopie (SNOM) eingesetzt werden, wobei bei einer Beleuchtung der Apertur von der Oberfläche des Halbleiterwafers die Apertur als miniaturisierte Lichtquelle im optischen Nahfeldbereich eingesetzt (sogenannter Illuminationmode) oder durch die Apertur selbst Lichtleistung von der beleuchteten Probe aufgenommen wird (sogenannter Collectionmode).

Durch sequentielle Deposition von Materialien, wie Metall, Halbleiter, Polymere auf Vorder- und/oder Rückseite des Biegebalkens wird eine miniaturisierte Kontaktstelle der Materialien an der Stelle der Apertur erhalten.

Eine weitere vorteilhafte Verwendung besteht darin, daß eine matrixförmige Anordnung der Aperturen beispielsweise in Form eines Arrays auf planen Substraten beziehungsweise strukturierten Oberflächen (zum Beispiel Cantilevern) zur Größensortierung von Partikeln nach Art eines Siebes eingesetzt wird.

Eine weitere Verwendung zeichnet sich dadurch aus, daß eine insbesondere matrixförmige Anordnung einer oder mehrere Aperturen auf planen Substraten oder auf strukturierten Oberflächen (zum Beispiel Cantilevern) für die Dosierung und/oder Injektion von exakten, sehr kleinen Flüssigkeits- oder Gasmengen eingesetzt wird.

Weitere Merkmale, Vorteile, Anwendungsmöglichkeiten und Ziele der Erfindung ergeben sich aus der nachfolgenden Beschreibung von Ausführungsbeispielen anhand der Zeichnungen. Dabei bilden alle beschriebenen und/oder bildlich dargestellten Merkmale für sich oder in beliebiger Kombination den Gegenstand der vorliegender Erfindung, auch unabhängig von ihrer Zusammenfassung in den Ansprüchen oder deren Rückbeziehung.

Es zeigen:
- Figur 1: einen Querschnitt durch eine anisotrop geätzte Grabenstruktur mit aufgebrachter Oxidschicht,
- Figur 2: in vergrößertem Maßstab einen Querschnitt durch die oxidierte Grabenstruktur der Figur 1, nachdem das Oxid um 75 nm angeätzt wurde,
- Figur 3: eine schematische Darstellung zweier Spitzen der Oxidschicht nach der Ätzung, wobei der angenommene Dickenunterschied des Halbleiterwafers gemäß Figur 3a, b zu freien Oxidspitzen führt, die unterschiedlich weit aus dem verbleibenden Halbleitermaterial herausragen, aber eine gleichgroße Apertur von ca. 150 nm aufweisen und Figur 3c eine Verkleinerung der Apertur durch einen folgenden Metallisierungsprozeß in schematischer Darstellung,

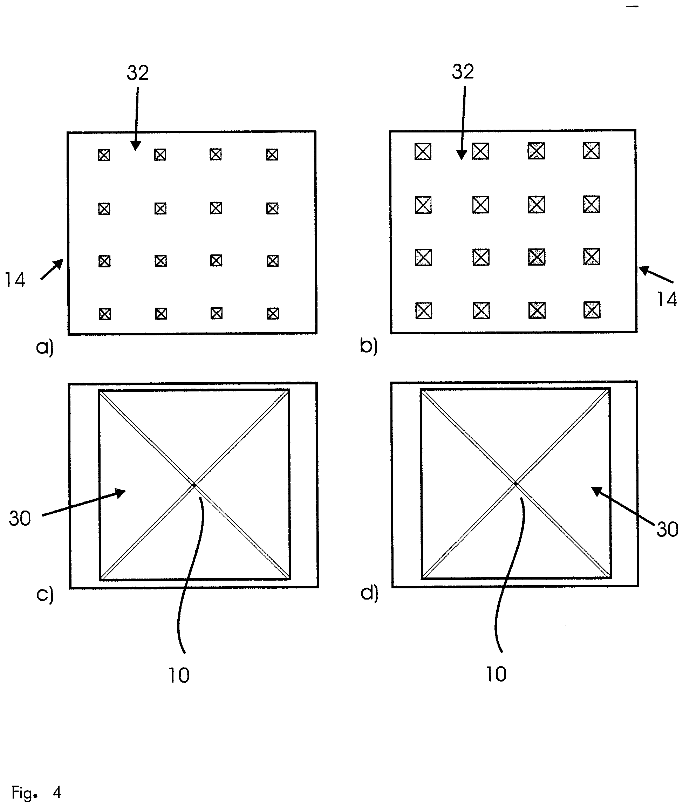

- Figur 4: REM-Aufnahmen oxidierter, inverser Pyramidenarrays, bei denen sämtliche Verfahrensschritte durchgeführt wurden. In Figur 4a ragen die Oxidspitzen ca. 4 Mikrometer aus dem verbleibenden Halbleitermaterial heraus, während in Figur 4b die Spitzen um ca. 6 Mikrometer aufgrund des längeren Ätzens des Halbleitermaterials herausstehen. Hierdurch wurde ein Dickenunterschied des Halbleiterwafers quasi simuliert. Die Figuren 4c und 4d sind vergrößerte Darstellungen der äußersten Spitze einer inversen Pyramide des darüberliegenden Arrays gemäß Figur 4a, b. Die Aperturen weisen Durchmesser von ca. 160 nm auf und sind weitestgehend identisch,
- Figur 5: gibt eine schematische Darstellung der einzelnen Prozeßschritte für die Apertursensorherstellung wieder und
- Figur 6: ist eine schematische Darstellung der Aperturerzeugung nach dem bekannten Stand der Technik.

Das Verfahren gemäß Figur 6 nach dem Stand der Technik zur Erzeugung von Aperturen 10 ist, wie bereits in der Einleitung dargestellt, äußerst sensibel auf Dickeschwankungen des Halbleiterwafers 14, die unabhängig von dem Herstellungsverfahren die Größe der Aperturen 10 beeinflussen. Diese Dickeschwankungen sind in Figur 6a durch die wellenförmige Unterfläche 18 des Halbleiterwafers 14 angedeutet. Nach dem anisotropen Ätzen der Unterfläche 18 ist die in Figur 6b linke Pyramidenspitze der inversen Pyramide 30 sehr weit zu einer Apertur 10 geöffnet, weil der Halbleiterwafer 14 an dieser Stelle dünner ist als in dem nachfolgenden mittleren Bereich. Dort ist die Dicke des Halbleiterwafers 14 in der schematischen Darstellung der Figur 6 gerade so gewählt, daß eine ideal kleine Apertur 10 entsteht. Demgegenüber ist die Dicke des Halbleiterwafers 14 im rechten Bereich der Figur 6b so dick, daß der anisotrope Ätzvorgang an der Unterfläche 18 überhaupt nicht zu einer Apertur führt. Dieses Beispiel eines Verfahrens nach dem Stand der Technik soll erläutern, daß Dickenvariationen des Halbleiterwafers 14 unmittelbar und nicht kontrollierbar in die herzustellende Größe der Apertur 10 eingehen.

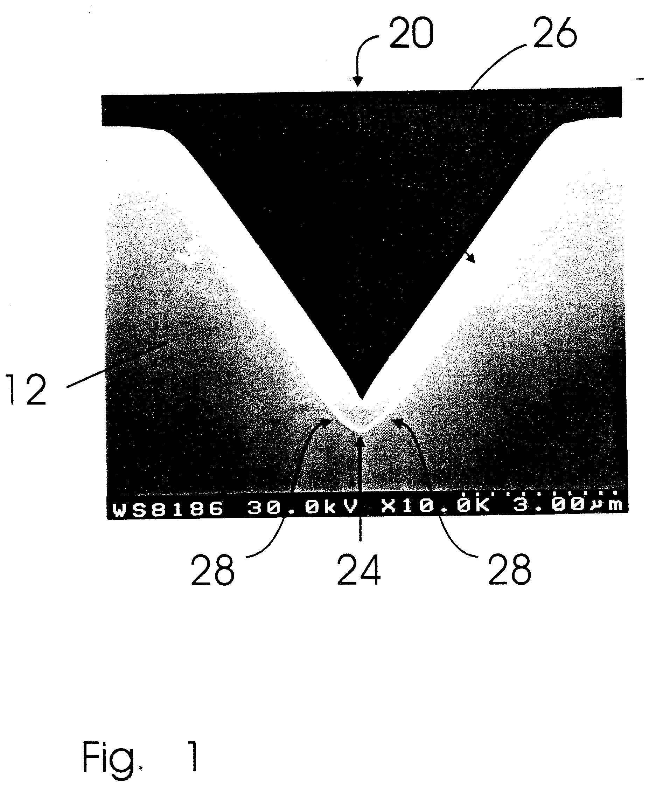

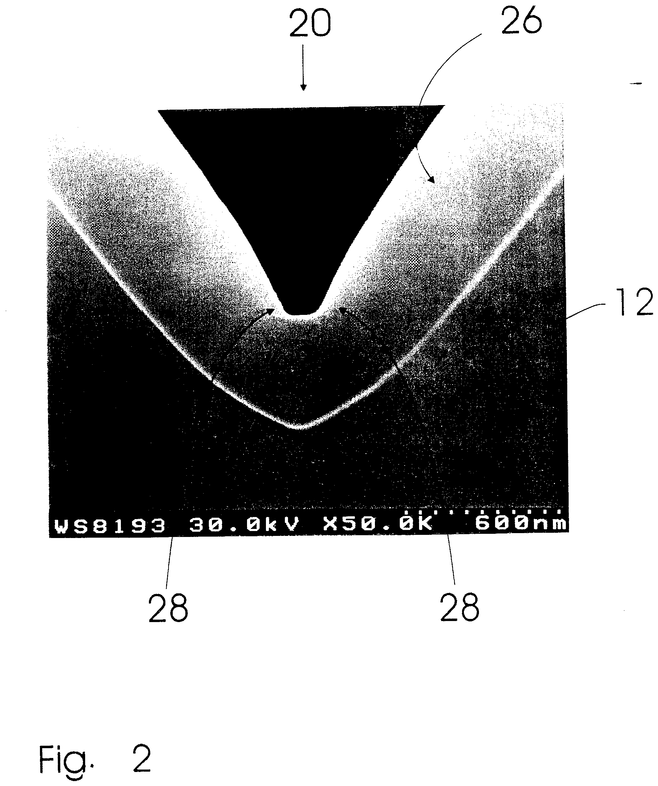

Die Figuren 1 und 2 zeigen Querschnitte durch eine Grabenstruktur in einem (100)-orientierten, bor-dotierten Siliziumwafer. Dazu wird der Siliziumwafer zunächst mit einer wenige 100 nm dicken Oxidschicht versehen und anschließend lithographisch strukturiert, bevor die Gräben anisotrop geätzt werden. Die gewünschte Spitzenhöhe des Apertursensors soll ca. 15 Mikrometer betragen, so daß die Basisbreite der Gräben von 8 Mikrometer bis 30 Mikrometer gewählt wird und die Tiefe der Gräben Werte zwischen 5 bis 6 Mikrometer und 21 Mikrometer annimmt. Nach dem anisotropen Ätzschritt wird das auf der Oberfläche verbliebene Oxid mit verdünnter Flußsäure entfernt. Vor dem eigentlichen Oxidationsprozeß wird eine optische Inspektion des Siliziumwafers durchgeführt. Kontaminierte Siliziumwafer werden einer Standard-RCA-Reinigung unterzogen, die Auswirkung auf die Qualität der anschließend erzeugten thermischen Oxide hat.

Um reproduzierbare Ergebnisse zu erhalten, wird die Reinigung immer durch kurzen Eintauchen des Siliziumwafers in stark verdünnte Flußsäure (1 HF:50 H₂O) und anschließendes gründliches Spülen mit vollentsalztem Wasser (Widerstand: 15 MQcm) beendet. Der Siliziumwafer wird unmittelbar anschließend in den Oxidationsofen überführt und bei ca. 900° C in feuchter Atmosphäre für ca. 2 Stunden oxidiert. Diese Vorgehensweise läßt die größten Streßeffekte und damit auch die inhomogenste Oxidschichtdicke erwarten.

Um Aussagen bezüglich der Oxidkonturen zu erhalten, wird der Siliziumwafer quer zu der Grabenstruktur gebrochen und rasterelektronenmikroskopisch untersucht. Zur Erhöhung des Kontrastes zwischen Oxidschicht 26 und Halbleitermaterial 12, beispielsweise Silizium, wird letzteres selektiv gegenüber der Oxidschicht 26 um wenige Mikrometer zurückgeätzt. Erwartungsgemäß ist die Oxidschicht auf der (111)-Wand am dicksten und zeigt Inhomogenitäten 28, insbesondere Schwachstellen an den Ecken, an denen die Oxidschichtdicke kleiner ist als auf der planaren (100)-orientierten Oberfläche. Die Oxidschicht 26 an den konvexen Ecken ist in der Regel dicker als die Oxidschicht an der konkaven Ecke an der Spitze der inversen Pyramide 30. Die Inhomogenität 28 beziehungsweise Verdünnung liegt nicht direkt unterhalb der konkaven Ecke, sondern ist in zwei Bereichen links und rechts der eigentlichen Spitze angesiedelt. Auf dem Weg zur Herstellung der Apertur 10 wird die Oxidschicht in der Grabenstruktur in einem folgenden Schritt isotrop um 75 nm abgedünnt. Anschließend wird die Probe erneut gebrochen und das Halbleitermaterial 12 beziehungsweise Silizium zur Kontrastverbesserung um wenige Mikrometer weggeätzt. In Figur 2 ist das Ergebnis im Anschluß an diesen Ätzvorgang dargestellt. Da der Ätzvorgang isotrop durchgeführt wird, erscheint der Bereich an der Spitze der Pyramide auf ca. 150 nm aufgeweitet, das heißt ca. 75 nm in jede Richtung. Dabei sind die Inhomogenitäten 28 beziehungsweise Schwachstellen noch deutlicher ausgeprägt als vor dem Ätzvorgang entsprechend Figur 1.

Diese Profile der Oxidschicht 26 gemäß den Figuren 1 und 2 können zur Herstellung einer Apertur 10 genutzt werden, wenn es gelingt, die Bodenbereiche 24 beziehungsweise die Spitzen der inversen Pyramiden 30 der Oxidschicht 26 freizulegen und diese dann vorsichtig isotrop zu ätzen, bis die Inhomogenitäten 28 beziehungsweise die Schwachstellen der Oxidschicht 26 durchtrennt, jedoch die Seitenwände 22 der Pyramidenwände noch erhalten sind. Um die pyramidenförmige Oxidschicht 26 freizulegen, wird in einem nächsten Schritt das Halbleitermaterial 12 zurückgeätzt. Das Ätzen wird dann abgebrochen, wenn alle Spitzen der Oxidschicht 26 aus der verbleibenden dünnen Schicht Halbleitermaterials 12 herausragen. Da die Oxidätzrate in KOH wesentlich kleiner ist als die Ätzrate in Silizium (Oxid: 0,06 Mikrometer/h, Silizium: 19,9 Mikrometer/h; 40 Gew. % KOH, 60° C), wird die Oxidschicht 26 bei diesem Schritt durch das selektive Ätzen des Halbleitermaterials 12 nicht oder nur geringfügig angegriffen. Für 20 Mikrometer hohe Pyramiden, die vollständig freigeätzt werden, wird die äußerste Spitze der Oxidpyramide gegenüber der Basis lediglich um ca. 60 nm abgedünnt, weil sie der Ätzflüssigkeit KOH entsprechend länger ausgesetzt ist. Für Substratdickenschwankungen von 5 Mikrometer resultieren Oxiddickenschwankungen einzelner Pyramiden von lediglich 50 nm, wenn die Oxidätzrate einer 40 Gew. % KOH bei 60° C zugrundegelegt wird. Anschließend wird in einem folgenden Schritt die Oxidpyramide vorsichtig isotrop um wenige Nanometer geätzt, so daß die Inhomogenitäten 28 beziehungsweise Schwachstellen oder Verjüngungen der Oxidschicht 26 durchtrennt werden können, wodurch Aperturen 10 entstehen, deren Abmessungen trotz Dickeschwankungen des Halbleiterwafers 14 äußerst reproduzierbar einstellbar sind.

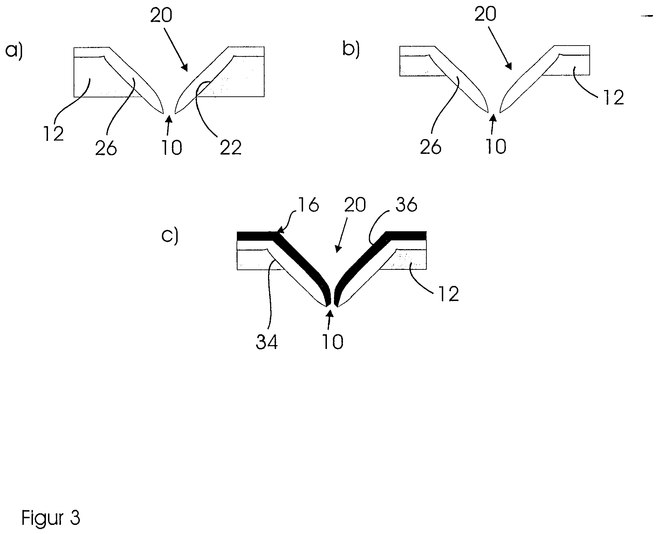

In Figur 3 ist dieser Sachverhalt schematisch verdeutlicht. Aus der Geometrie der Dicke der Oxidschicht 26 gemäß Figur 2 ist zu erkennen, daß sich geringe Schwankungen der Oxidschichtdicke an der Spitze der inversen Pyramide 30 praktisch nicht auf die entstehende Größe der Apertur 10 auswirken.

Insbesondere bei der Anwendung derartiger Aperturen 10 in optischen Nahfeldsensoren ist in der Regel eine Metallisierung notwendig, die in Figur 3c als Metallschicht 36 bestehend aus insbesondere Aluminium dargestellt ist. Diese Aufbringung der Metallschicht kann zu einer weiteren Verringerung der Abmessungen der Apertur 10 genutzt werden. Aus Figur 3a und b wird ersichtlich, daß unterschiedliche Dicken des Halbleiterwafers 14 einen Einfluß auf den Durchmesser beziehungsweise die Größe der Apertur 10 nicht ausüben. Dabei ist die Variation der Schichtdicke durch die seitlich des Halbleitermaterials 12 angeordneten Pfeile verdeutlicht, wobei trotz variierender Schichtdicke der Durchmesser der Apertur 10 unverändert ist.

In Figur 4 sind REM-Aufnahmen oxidierter inverser PyramidenArrays dargestellt, bei denen alle notwendigen Schritte zur Erzeugung der Aperturen 10 durchgeführt sind. Die PyramidenArrays, bei denen die Vertiefungen 20 in gleichmäßigen seitlichen Abständen positioniert sind, werden wie beschrieben oxidiert, angeätzt und so freigelegt, daß Bodenbereiche 24 der Oxidschicht 26 vorhanden sind, die aus dem verbleibenden Halbleitermaterial 12 unterschiedlich weit - je nach Dickenschwankung des Halbleitermaterials 12 beziehungsweise des Halbleiterwafers 14 - herausstehen. Um die Aperturen 10 zu erzeugen, werden die Oxidschichtpyramiden vorsichtig angeätzt, bis die Aperturen 10 aufgrund eines Durchtrennens der Inhomogenitäten 28 beziehungsweise der Schwachstellen der Oxidschicht 26 entstehen. In Figur 4a stehen die Spitzen der Oxidschicht 26 ca. 4 Mikrometer aus der Unterfläche 18 heraus. In Figur 4b stehen die Spitzen ca. 6 Mikrometer aus der Unterfläche 18 heraus, was durch ein längeres Ätzen hervorgerufen wurde. Durch diese Maßnahme wird praktisch eine Dickenschwankung der Schicht des Halbleitermaterials 12 beziehungsweise des Halbleiterwafers 14 simuliert. In den Abbildungen 4c, d sind jeweils eine inverse Pyramide 30 des darüberliegenden Arrays 4a, b vergrößert dargestellt, wobei durch vorsichtiges Anätzen der Oxidschicht 26 Aperturen 10 im Bereich von 160 nm erzeugt worden sind. Obwohl in diesem Beispiel durch unterschiedliche Ätzraten Dickenschwankungen des Halbleiterwafers 14 von ca. 2 Mikrometer simuliert worden sind, unterscheiden sich die Dimensionen der Aperturen 10 in den Fällen Figur 4a, c im Vergleich zu den Fällen 4b, d praktisch nicht. Somit ist auch experimentell ein Nachweis darüber geführt, daß nach dem erfindungsgemäßen Verfahren hergestellte Aperturen 10 bezüglich der Dimensionierung der Aperturen 10 äußerst reproduzierbar und insbesondere unabhängig von Dickeschwankungen des Halbleiterwafers 14 herstellbar sind.

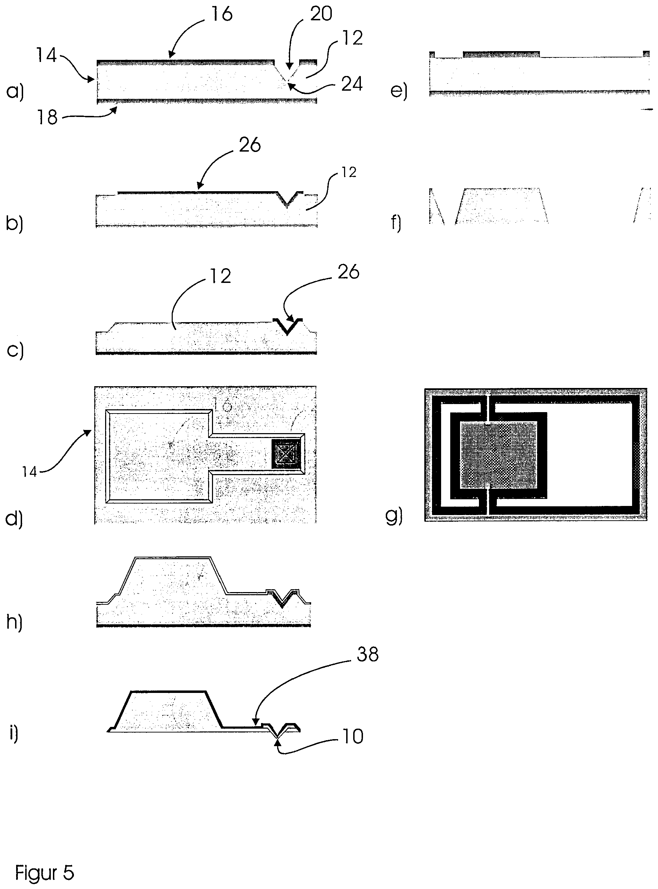

In Figur 5 sind schematisch die einzelnen Verfahrensschritte zur Herstellung eines Apertursensors dargestellt. In Figur 5a ist die Definition und das Resultat des Ätzvorganges der inversen Pyramide 30 wiedergegeben. In Figur 5b wird die Cantilever- beziehungsweise Biegebalkenstruktur in den erneut oxidierten und vorbehandelten Halbleiterwafer 14 übertragen. Gemäß Figur 5c ist die Umgebung des Biegebalkens beziehungsweise Cantilevers abgesenkt und die verbliebene Oxidschicht 26 mit Ausnahme des Bereichs der Vertiefung 20 entfernt. Figur 5d zeigt eine Aufsicht auf den Halbleiterwafer-14, gemäß Figur 5e wird das Halteelement in der Oxidschicht eines zweiten Halbleiterwafers 14 definiert. Mittels anisotropen Ätzens wird gemäß Figur 5f das in einem Rahmen fixierte Halteelement erzeugt. Figur 5g zeigt eine Aufsicht auf den zweiten Halbleiterwafer. In Figur 5h ist in einer Schnittdarstellung dargestellt, wie beide Halbleiterwafer gefügt und mit einer Siliziumnitrid-Schicht versehen sind. Figur 5i zeigt die Trennung des Biegebalkens beziehungsweise Cantilevers von dem Substrat mittels eines anisotropen Ätzschritts. Die Siliziumnitrid-Schicht wird entfernt. Ein Metallisierungsprozeß mit Aluminium beendet den Herstellungsprozeß.

Die entsprechend dem erfindungsgemäßen Verfahren herstellten Aperturen können als Ausgangspunkt für die Realisierung verschiedenartiger mikromechanischer Bauelemente benutzt werden. Da die Öffnungsgröße gezielt und reproduzierbar beispielsweise bei einem Array eingestellt werden kann, ist zum Beispiel eine Anwendung zur Größentrennung von Partikeln in einer siebförmigen Anordnung einer Vielzahl von Aperturen 10 möglich. Ebenso können diese Aperturen 10 zur Injektion kleinster Gas- oder Flüssigkeitsmengen oder dergleichen in der Medizin, Biologie und Chemie eingesetzt werden. Ein anderer wichtiger Anwendungsfall ist in der Sensorik zu sehen.

Werden die Öffnungen in die hohle Spitze von Biegebalkensonden (Cantilever) integriert, so lassen sich diese als Ausgangselement für die Realisierung verschiedener Sonden für die Messung unterschiedlichster physikalischer und chemischer Parameter in der Rastersondenmikroskopie benutzen. Cantileversonden sind einseitig eingespannte Biegebalken mit einer am Ende des Balkens integrierten Spitze, die über eine zu untersuchende Probenoberfläche gerastert wird, um die Topographie und zusätzliche physikalische und/oder chemische Eigenschaften von Probenoberflächen in verschiedenster Umgebung, zum Beispiel Luft, Vakuum, Flüssigkeiten, zu untersuchen.

Beispielsweise kann eine miniaturisierte Öffnung in einer hohlen Spitze für die Untersuchung der optischen Oberflächeneigenschaften auf der Basis der optischen Rasternahfeldmikroskopie (SNOM) benutzt werden. Dabei kann die die Öffnung beziehungsweise Apertur tragende Spitze in einem Cantilever integriert oder als Element auf einer optischen Faser aufgeklebt sein. Zur Verbesserung der optischen Eigenschaften können die spitzenförmigen Aperturen mit dünnen Metallspitzen verstärkt werden. Die Vertiefungen mit den Öffnungen können zu dem gleichen Zweck auch spalten- und zeilenweise in Biegebalken oder planen Substraten angeordnet werden, um eine parallele Arbeitsweise, zum Beispiel für die parallele Bildaufnahme oder die parallele Datenspeicherung mit Hilfe der SNOM zu erreichen.

Wird eine mit einem Material von oben beschichtete Spitze von der Unterfläche 18 ebenfalls beschichtet, so können in dieser Weise kleinster Kontakte realisiert werden, die im wesentlichen die Größe der Apertur 10 aufweisen. Diese Art von Kontakten können in vielfältiger Weise für in die Spitze integrierte Sensorelemente benutzt werden. Ein typisches Beispiel ist ein Metall/Metall oder Metall/Halbleiterkontakt, der als Thermoelement zur lokalen Temperaturmessung nutzbar ist.

Wird die Spitze der Oxidschicht 26 von der Unterfläche 18 mit einer metallischen Schicht versehen, so kann in Abhängigkeit von der Dicke der Metallschicht die Oxidöffnung nach oben verschlossen werden. Im Bereich der Spitze bleibt jedoch ein miniaturisiertes Behältnis im Bereich von Attolitern. Zur elektrischen Isolierung dieser Metallschicht gegenüber der Umgebung wird ein dünner dielektrischer Film, zum Beispiel Siliziumnitrid oder Siliziumoxid, von der Rückseite des Biegebalkens aufgedampft. Der Sensor kann so in flüssiger Umgebung betrieben und mittels der isolierten Metallschicht ein galvanischer Strom gemessen werden, der nur an der vorderen metallischen Spitze vorliegt. Diese Sonden können, beispielsweise wiederum in Spitzen integriert, als Sonden für die elektrochemische Untersuchung von Oberflächen auf der Basis der Scanning Electrochemichal Microscopie (SECM) eingesetzt werden.

Werden Oxidstrukturen mit schneidenförmiger Spitzenstruktur hergestellt, so lassen sich gegebenenfalls zwei Öffnungen in die Spitze der Oxidschicht beziehungsweise den Bodenbereich 24 einätzen. Dabei sind die beiden Aperturen 10 durch einen Oxidsteg voneinander getrennt. Dieser miniaturisierte Steg kann mit einem weiteren Material, zum Beispiel Metall, halbleitenden Materialien, organischen Materialien oder dergleichen, beschichtet werden. So läßt sich in einfacher Weise ein balkenförmiger, miniaturisierter elektrischer Leiter herstellen. Diese Anordnung kann zum Beispiel für die thermische Rastersondenmikroskopie (SThM) ausgenutzt werden, indem der von der Temperatur abhängige Widerstand der Leiterbahn zur Messung der lokalen Probentemperatur eingesetzt wird.

Werden Oxidstrukturen mit plateauförmiger Struktur an der zulaufenden Seite des Stumpfes der Oxidschicht 26 hergestellt, so lassen sich gegebenenfalls vier Öffnungen in die Spitze der Oxidschicht 26 einätzen. Die vier Öffnungen sind dabei durch eine kreuzförmige Oxidstruktur voneinander getrennt. Dieses miniaturisierte Kreuz kann dann mit einem weiteren Material, zum Beispiel Metall, halbleitenden Materialien, organischen Materialien oder dergleichen, beschichtet werden und als miniaturisierte Hohlsonde zur Messung von Magnetfeldern verwendet werden. Ebenso besteht die Möglichkeit, die matrixförmige Anordnung der Aperturen 10 auf planen Substraten oder der Spitzen beziehungsweise Bodenbereichen 24 auf strukturierten Oberflächen, zum Beispiel Cantilevern, für die Injektion von sehr kleinen, exakt dosierten Flüssigkeitsmengen zu benutzen.

Insgesamt besteht der Vorteil der vorliegenden Erfindung darin, ein Verfahren entwickelt zu haben, welches es ermöglicht, an jeder Spitze beziehungsweise an jedem Bodenbereich 24 der Oxidschicht 26, gezielt die Größe der herzustellenden Apertur 10 zu bestimmen. Dies wird dadurch bewerkstelligt, daß durch den Stress in der Oxidschicht 26 an der Spitze, das heißt im Bereich der größten Krümmung eine lokal definierte, höhere Ätzrate realisierbar ist. Somit kann durch die spezielle Wahl der Ätzzeit die geätzte Oxidschichtdicke im Bereich der Spitze beziehungsweise des Bodenbereichs 24 bestimmt werden, so daß Dickenschwankungen der Halbleiterwafer 14 keinen Einfluß auf die Größe der Apertur 10 haben.

### Bezugszeichenliste

- 10: Apertur
- 12: Halbleitermaterial
- 14: Halbleiterwafer
- 16: Oberfläche
- 18: Unterfläche
- 20: Vertiefung
- 22: Seitenwand
- 24: Bodenbereich
- 26: Oxidschicht
- 28: Inhomogenität
- 30: inverse Pyramide
- 32: Array
- 34: Innenwandung
- 36: Metallschicht
- 38: Biegebalken

## Patentansprüche

1. Verfahren zur Herstellung einer Apertur (10), deren mittlerer Durchmesser unterhalb von einem Mikrometer, liegt, in einem Halbleitermaterial (12), mit folgenden Schritten:
1.1 Bereitstellen eines Halbleiterwafers (14), mit einer Oberfläche (16) und einer Unterfläche (18),
1.2 Erzeugen einer Vertiefung (20) in der Oberfläche (16) des Halbleiterwafers (14) mit einer Seitenwand (22) durch partielles, anisotropes Anätzen der Oberfläche (16),
**dadurch gekennzeichnet, dass**
1.3 die Vertiefung (20) einen der Unterfläche (18) zugewandten, geschlossenen Bodenbereich (24) mit wenigstens einer konvexen oder konkaven Ecke oder Kante aufweist,
1.4 Aufbringen einer Oxidschicht (26) auf dem Halbleitermaterial (12) wenigstens im Bereich der Vertiefung (20) durch Oxidation des Halbleitermaterials (12), wobei die Oxidschicht (26) wenigstens im Bodenbereich (24) eine Inhomogenität (28) im Bereich der konvexen oder konkaven Ecke oder Kante aufweist,
1.5 selektives Rückätzen des Halbleitermaterials (12) an der Unterfläche (18) des Halbleiterwafers (14) bis zum Freilegen wenigstens der im Bodenbereich (24) befindlichen Oxidschicht (26),
1.6 Anätzen der freigelegten Oxidschicht (26) bis wenigstens zu deren Durchtrennung im Bereich der Inhomogenität (28) der Oxidschicht, so dass eine Apertur (10) in der Oxidschicht (26) gebildet wird, wobei die Größe der Apertur (10) durch einen Stress in der Oxidschicht (26) bestimmt wird, wobei im Bereich der größten Krümmung an der Spitze eine lokal höhere Ätzrate realisiert ist.

2. Verfahren nach Anspruch 1, **dadurch gekennzeichnet, dass** die Vertiefung (20) die Form einer inversen Pyramide (30) oder eines V-förmigen Grabens oder eines inversen Pyramidenstumpfes oder einer Plateauform aufweist.

3. Verfahren nach Anspruch 1 oder 2, **dadurch gekennzeichnet, dass** eine Vielzahl von Vertiefungen (20) auf der Oberfläche (16) des Halbleiterwafers (14) erzeugt werden.

4. Verfahren nach einem der vorhergehenden Ansprüche, **dadurch gekennzeichnet, dass** die Oxidschicht (26) im Bodenbereich (24) als Inhomogenität eine oder mehrere Schwachstellen oder Verjüngungen aufweist.

5. Verfahren nach einem der vorhergehenden Ansprüche, **dadurch gekennzeichnet, dass** die Oxidschicht (26) nach dem Durchtrennen einem Metallisierungsprozess unterworfen wird.

6. Verfahren nach einem der vorhergehenden Ansprüche, **dadurch gekennzeichnet, dass** der mittlere Durchmesser der Apertur (10) in der Größenordnung von 100 nm oder weniger liegt.

7. Verfahren nach einem der vorhergehenden Ansprüche, **dadurch gekennzeichnet, dass** die Vertiefungen (20) durch anisotropes Ätzen erzeugt werden.

8. Verfahren nach einem der vorhergehenden Ansprüche, **dadurch gekennzeichnet, dass** die Oxidschicht (26) durch Erhitzen des Halbleiterwafers (14) auf 900° C in feuchter Atmosphäre für 2 Stunden erzeugt wird.

9. Verfahren nach einem der vorhergehenden Ansprüche, **dadurch gekennzeichnet, dass** das selektive Rückätzen des Halbleitermaterials (12) isotrop oder anisotrop erfolgt.

10. Verfahren nach einem der Ansprüche 3 bis 9, **dadurch gekennzeichnet, dass** das selektive Rückätzen des Halbleitermaterials (12) so lange erfolgt, bis die Oxidschichten (26) aller oder einer Mehrzahl der Vertiefungen (20) freigelegt sind.

11. Verfahren nach einem der vorhergehenden Ansprüche, **dadurch gekennzeichnet, dass** das Anätzen der freigelegten Oxidschicht (26) mit Ammoniumfluoridpuffer durchgeführt wird.

12. Verfahren nach einem der vorhergehenden Ansprüche, **dadurch gekennzeichnet, dass** die Größe der Apertur (10) durch die Dauer des Anätzens der Oxidschicht (26) nach deren Durchtrennung hin zu größeren Werten variierbar ist.

13. Verfahren nach einem der vorhergehenden Ansprüche, **dadurch gekennzeichnet, dass** die Vertiefung (20) schneidenförmig zulaufend ausgebildet ist und insbesondere je Vertiefung zwei beziehungsweise vier Aperturen (10) hergestellt werden.

14. Verwendung einer nach einem Verfahren gemäß einem der Ansprüche 1 - 13 hergestellten Apertur (10), wobei die Apertur durch eine auf einer Innenwand (34) einer Durchbrechung im Halbleitermaterial (12) befindlichen Oxidschicht (26) gebildet ist in dem vorderen Bereich eines einseitig eingespannten Biegebalkens (38).

15. Verwendung nach Anspruch 14, **dadurch gekennzeichnet, dass** der Biegebalken (38) einzeln oder eine Mehrzahl von Biegebalken (38) in einer Matrixanordnung als Sensorelement beziehungsweise Sensorelemente eingesetzt werden.

16. Verwendung nach einem der Ansprüche 14 oder 15, **dadurch gekennzeichnet, dass** der oder die Biegebalken (38) als Sensorelemente in der Rastersonden-Mikroskopie eingesetzt werden.

17. Verwendung nach einem der vorhergehenden Ansprüche 14 bis 16, **dadurch gekennzeichnet, dass** durch Deposition einer dünnen, optisch wenig transparenten Schicht der oder die Biegebalken (38) für die simultane Rasterkraftmikroskopie (AFM, SFM) oder die optische Rasternahfeldmikroskopie (SNOM) eingesetzt werden, wobei bei einer Beleuchtung der Apertur (10) von der Oberfläche (16) des Halbleiterwafers (14) die Apertur (10) als miniaturisierte Lichtquelle im optischen Nahfeldbereich eingesetzt oder durch die Apertur (10) Lichtleistung von der beleuchteten Probe aufgenommen wird.

18. Verwendung nach einem der Ansprüche 14 oder 15, **dadurch gekennzeichnet, dass** durch sequentielle Deposition von Materialien wie Metallen, Halbleitern oder Polymeren auf der Oberfläche (16) und Unterfläche (18) des Biegebalkens (38) eine miniaturisierte Kontaktstelle der Materialien an der Stelle der Apertur (10) erhalten wird.

19. Verwendung einer nach einem Verfahren gemäß einem der Ansprüche 1 bis 13 hergestellten Apertur (10), wobei die Apertur durch eine auf einer Innenwandung (34) einer Durchbrechung im Halbleitermaterial (12) befindlichen Oxidschicht (26) gebildet ist,
**dadurch gekennzeichnet, dass**
eine maxtrixförmige Anordnung mehrerer Aperturen (10) auf planen Substraten beziehungsweise strukturierten Oberflächen zur Größensortierung von Partikeln nach Art eines Siebes eingesetzt wird.

20. Verwendung einer Apertur (10) nach einem der Ansprüche 14 oder 15 in einer insbesondere matrixförmigen Anordnung
**dadurch gekennzeichnet, dass**
einer oder mehrerer Aperturen (10) auf planen Substraten oder auf strukturierten Oberflächen für die Dosierung und/oder Injektion von exakten, sehr kleinen Flüssigkeits- oder Gasmengen eingesetzt wird.

## Claims

1. Method for producing an aperture (10), whose average diameter is less than one micrometer, in a semiconductor material (12), comprising the following steps:
1.1 providing a semiconductor wafer (14) having a surface (16) and a bottom surface (18),
1.2 producing a depression (20) in the surface (16) of the semiconductor wafer (14) with a side wall (22) by partial, anisotropic etching of the surface (16),
**characterized in that**
1.3 the depression (20) has a closed bottom region (24) facing the bottom surface (18) and having at least one convex or concave corner or edge,
1.4 applying an oxide layer (26) on the semiconductor material (12) at least in the region of the depression (20) by oxidation of the semiconductor material (12), wherein the oxide layer (26), at least in the bottom region (24), has an inhomogeneity (28) in the region of the convex or concave corner or edge,
1.5 selectively etching back the semiconductor material (12) on the bottom surface (18) of the semiconductor wafer (14) until exposing at least the oxide layer (26) located in the bottom region (24),
1.6 etching the exposed oxide layer (26) until at least its separation in the region of inhomogeneity (28) of the oxide layer, so that an aperture (10) is formed in the oxide layer (26), wherein the size of the aperture (10) is determined by stress in the oxide layer (26), wherein a locally higher etching rate is realized in the region of the greatest curvature at the tip.

2. Method according to claim 1, **characterized in that** the depression (20) has the shape of an inverse pyramid (30) or a V-shaped trench or an inverse truncated pyramid or a plateau shape.

3. Method according to claim 1 or 2, **characterized in that** a plurality of depressions (20) are produced on the surface (16) of the semiconductor wafer (14).

4. Method according to one of the preceding claims, **characterized in that** the oxide layer (26) in the bottom region (24) has one or more weak points or taperings as an inhomogeneity.

5. Method according to one of the preceding claims, **characterized in that** the oxide layer (26) is subjected to a metallization process after separation.

6. Method according to one of the preceding claims, **characterized in that** the average diameter of the aperture (10) is of the order of 100 nm or less.

7. Method according to one of the preceding claims, **characterized in that** the depressions (20) are produced by anisotropic etching.

8. Method according to one of the preceding claims, **characterized in that** the oxide layer (26) is produced by heating the semiconductor wafer (14) to 900°C in a humid atmosphere for 2 hours.

9. Method according to one of the preceding claims, **characterized in that** the selective etching back of the semiconductor material (12) is carried out isotropically or anisotropically.

10. Method according to one of the claims 3 to 9, **characterized in that** the selective etching back of the semiconductor material (12) takes place until the oxide layers (26) of all or a plurality of the depressions (20) are exposed.

11. Method according to one of the preceding claims, **characterized in that** the etching of the exposed oxide layer (26) is carried out with ammonium fluoride buffer.

12. Method according to one of the preceding claims, **characterized in that** the size of the aperture (10) can be varied to larger values by the duration of the etching of the oxide layer (26) after its separation.

13. Method according to one of the preceding claims, **characterized in that** the depression (20) is formed tapering in the shape of a blade and in particular two or four apertures (10) are produced per depression.

14. Use of an aperture (10) produced by a method according to one of the claims 1 to 13, wherein the aperture is formed by an oxide layer (26) located on an inner wall (34) of a breakthrough in the semiconductor material (12) in the front region of a bending beam (38) clamped on one side.

15. Use according to claim 14, **characterized in that** the bending beam (38) individually or a plurality of bending beams (38) are used in a matrix arrangement as a sensor element or sensor elements.

16. Use according to one of the claims 14 or 15, **characterized in that** the one or more bending beams (38) are used as sensor elements in scanning probe microscopy.

17. Use according to one of the preceding claims 14 to 16, **characterized in that** one or more bending beams (38) are used for simultaneous atomic force microscopy (AFM, SFM) or optical scanning near-field microscopy (SNOM) by deposition of a thin, optically less transparent layer, wherein when the aperture (10) is illuminated by the surface (16) of the semiconductor wafer (14), the aperture (10) is used as a miniaturized light source in the near-field optical field or light power is absorbed by the illuminated sample through the aperture (10).

18. Use according to one of claims 14 or 15, **characterized in that** by sequential deposition of materials such as metals, semiconductors or polymers on the surface (16) and bottom surface (18) of the bending beam (38) a miniaturized contact point of the materials is obtained at the location of the aperture (10).

19. Use of an aperture (10) produced by a method according to one of the claims 1 to 13, wherein the aperture is formed by an oxide layer (26) located on an inner wall (34) of a breakthrough in the semiconductor material (12), **characterized in that** a maxtrix-shaped arrangement of a plurality of apertures (10) on flat substrates or structured surfaces is used for size sorting of particles in the manner of a sieve.

20. Use of an aperture (10) according to one of the claims 14 or 15 in an especially matrix-shaped arrangement, **characterized in that** one or more apertures (10) on flat substrates or on structured surfaces are used for the dosage and/or injection of exact, very small liquid or gas quantities.

## Revendications

1. Procédé pour la fabrication d'une ouverture (10) d'un diamètre moyen inférieur à un micromètre dans un matériau semi-conducteur (12), comprenant les étapes suivantes :
1.1 préparation d'une plaquette de semi-conducteur (14), avec une surface supérieure (16) et une surface inférieure (18),
1.2 création d'un creux (20) dans la surface supérieure (16) de la plaquette de semi-conducteur (14) avec une paroi latérale (22) par attaque chimique anisotrope partielle de la surface supérieure (16),
**caractérisé en ce que**
1.3 le creux (20) présente une zone de fond (24) fermée tournée vers la surface inférieure (18), avec au moins un coin ou une arête convexe ou concave,
1.4 une couche d'oxyde (26) est appliquée sur le matériau semi-conducteur (12) au moins dans la zone du creux (20) par oxydation du matériau semi-conducteur (12), la couche d'oxyde (26) présentant au moins dans la zone de fond (24) une inhomogénéité (28) au niveau du coin ou de l'arête convexe ou concave,
1.5 gravure en retrait sélective du matériau semi-conducteur (12) sur la surface inférieure (18) de la plaquette de semi-conducteur (14) jusqu'à ce que la couche d'oxyde (26) se trouvant dans la zone de fond (24), au minimum, soit dégagée,
1.6 attaque chimique de la couche d'oxyde (26) dégagée au moins jusqu'à ce qu'elle se détache dans la zone de l'inhomogénéité (28) de la couche d'oxyde, de façon à former une ouverture (10) dans la couche d'oxyde (26), la taille de l'ouverture (10) étant déterminée par une tension dans la couche d'oxyde (26) de sorte qu'un taux de décapage plus élevé localement soit obtenu au sommet de la zone de plus forte courbure.

2. Procédé selon la revendication 1, **caractérisé en ce que** le creux (20) a la forme d'une pyramide renversée (30) ou d'une tranchée en forme de V ou d'une pyramide tronquée renversée ou d'un plateau.

3. Procédé selon la revendication 1 ou 2, **caractérisé en ce que** plusieurs creux (20) sont formés sur la surface supérieure (16) de la plaquette de semi-conducteur (14).

4. Procédé selon l'une des revendications précédentes, **caractérisé en ce que** la couche d'oxyde (26) présente comme inhomogénéité dans la zone de fond (24) un ou plusieurs points faibles ou strictions.

5. Procédé selon l'une des revendications précédentes, **caractérisé en ce que** la couche d'oxyde (26) est soumise, après sa séparation, à un processus de métallisation.

6. Procédé selon l'une des revendications précédentes, **caractérisé en ce que** le diamètre moyen de l'ouverture (10) est de l'ordre de 100 nm ou moins.

7. Procédé selon l'une des revendications précédentes, **caractérisé en ce que** les creux (20) sont produits par décapage anisotrope.

8. Procédé selon l'une des revendications précédentes, **caractérisé en ce que** la couche d'oxyde (26) est produite par chauffage de la plaquette de semi-conducteur (14) à 900 °C dans une atmosphère humide pendant 2 heures.

9. Procédé selon l'une des revendications précédentes, **caractérisé en ce que** la gravure en retrait sélective du matériau semi-conducteur (12) est isotrope ou anisotrope.

10. Procédé selon l'une des revendications 3 à 9, **caractérisé en ce que** la gravure en retrait sélective matériau semi-conducteur (12) dure jusqu'à ce que les couches d'oxyde (26) de tous ou plusieurs des creux (20) soient dégagées.

11. Procédé selon l'une des revendications précédentes, **caractérisé en ce que** l'attaque chimique de la couche d'oxyde (26) dégagée est effectuée avec un tampon de fluorure d'ammonium.

12. Procédé selon l'une des revendications précédentes, **caractérisé en ce que** la taille de l'ouverture (10) peut être agrandie par la durée de l'attaque chimique de la couche d'oxyde (26) après sa séparation.

13. Procédé selon l'une des revendications précédentes, **caractérisé en ce que** le creux (20) se resserre en forme de lame et, en particulier, deux ou quatre ouvertures (10) sont réalisées pour chaque creux.

14. Utilisation d'une ouverture (10) réalisées par un procédé selon l'une des revendications 1 à 13, dans lequel l'ouverture est formée par une couche d'oxyde (26) qui se trouve sur une paroi intérieure (34) d'une percée dans le matériau semi-conducteur (12) dans la zone antérieure d'une barre flexible (38) serrée d'un côté.

15. Utilisation selon la revendication 14, **caractérisée en ce que** la barre flexible (38) est insérée seule ou plusieurs barres flexibles (38) sont insérées dans une disposition de matrice comme élément ou éléments de capteur.

16. Utilisation selon l'une des revendications 14 ou 15, **caractérisée en ce que** la ou les barres flexibles (38) sont insérées comme éléments de capteurs en microscopie à sonde locale.

17. Utilisation selon l'une des revendications 14 à 16, **caractérisée en ce que** la ou les barres flexibles (38) sont insérées par dépôt d'une fine couche, peu transparente du point de vue optique, pour la microscopie à force atomique (AFM, SFM) ou la microscopie optique en champ proche (SNOM), l'ouverture (10) étant insérée, lorsque l'ouverture (10) est éclairée par la surface supérieure (16) de la plaquette de semi-conducteur (14), pour servir de source lumineuse miniaturisée dans la zone de champ proche optique ou l'ouverture (10) absorbant la puissance lumineuse de l'échantillon éclairé.

18. Utilisation selon l'une des revendications 14 ou 15, **caractérisée en ce qu'**un point de contact miniaturisé des matériaux au point de l'ouverture (10) est obtenu par le dépôt successif de matériaux tels que des métaux, des semiconducteurs ou des polymères sur la surface supérieure (16) et la surface inférieure (18) de la barre flexible (38).

19. Utilisation d'une ouverture (10) réalisée par un procédé selon l'une des revendications 1 à 13, dans laquelle l'ouverture est formée par une couche d'oxyde (26) qui se trouve sur une paroi intérieure (34) d'une percée dans le matériau semi-conducteur (12), **caractérisée en ce qu'**une disposition en forme de matrice de plusieurs ouvertures (10) est insérée sur des substrats plans ou des surfaces structurées pour le tri par taille de particules à la manière d'un crible.

20. Utilisation d'une ouverture (10) selon l'une des revendications 14 ou 15 en particulier dans une disposition de matrice, **caractérisée en ce qu'**une ou plusieurs ouvertures (10) sont insérées sur des substrats plans ou des surfaces structurées pour le dosage et/ou l'injection de quantités précises et très petites de liquide ou de gaz.
